# EUROPEAN PATENT SPECIFICATION

(11) **EP 4 244 905 B1**
(45) Date of publication and mention of the grant of the patent: **07.01.2026**
(21) Application number: 21891346.5
(22) Date of filing: 12.11.2021
(51) Int. Cl.: H10H 20/00

(54) **SUPER-BROADBAND CONTINUOUS SPECTRUM SUPERLUMINESCENT LIGHT EMITTING DIODE**
SUPERBREITBANDIGE SUPERLUMINESZENZ-LEUCHTDIODE MIT KONTINUIERLICHEM SPEKTRUM
DIODE ÉLECTROLUMINESCENTE SUPERLUMINESCENTE À SPECTRE CONTINU À BANDE ULTRALARGE

(30) Priority: 12.11.2020 US 202063113000 P
(43) Date of publication of application: 20.09.2023
(73) Proprietor: Denselight Semiconductors Pte Ltd, Singapore 498831 (SG)
(72) Inventor: CHAN, Yuen Chuen, Singapore 138678 (SG); LAM, Yee Loy, Singapore 426094 (SG)
(74) Representative: Cabinet Chaillot
(86) International application number: PCT/IB2021/060529
(87) International publication number: WO 2022/101859

(56) References cited:
- EP-A1- 3 691 062
- JP-A- 2007 184 557
- JP-A- 2012 033 797
- US-A- 5 689 358
- US-A1- 2010 259 758
- US-A1- 2011 303 892
- US-A1- 2015 263 219
- US-A1- 2016 190 386

## Description

### FIELD OF THE DISCLOSURE

Various embodiments of the disclosure relate generally to superluminescent light emitting diode (SLED). More particularly, various embodiments of the present disclosure relate to super-broadband continuous spectrum SLED.

### BACKGROUND

An incoherent source of light is the key for enabling an optical component in photonics sensing systems based on optical interferometry. The applications of incoherent source of light are found in Optical Coherence Tomography (OCT), where the low incoherent light is used to obtain two-dimensional (D) and three-D images from an optical scattering medium.

Conventional SLED is an incoherent solid-state semiconductor-based light source that is typically deployed in the photonics sensing systems. A conventional SLED has high spectral ripple and a low optical bandwidth. Hence, conventional SLEDs are not suited to meet the requirements of sub-micron imaging systems for OCT.

Conventional SLEDs of the prior art are disclosed for example in EP3691062 A1 and US 2010/259758 A1.

### SUMMARY

In an embodiment of the present disclosure, a super luminescent light emitting diode (SLED) is provided. The SLED comprises a single continuous contact pad, a resistance array, and an active waveguide. The single continuous contact pad is configured as an electrode. The resistance array is coupled with the single continuous contact pad and comprises a plurality of resistors. The active waveguide has a varying bandgap and is divided into a plurality of longitudinal sections. The active waveguide is configured to emit a superluminescent broadband light based on the varying bandgap and an electric current injected in the active waveguide. The electric current is injected in the active waveguide by the single continuous contact pad by way of the resistance array. Each longitudinal section of the plurality of longitudinal sections of the active waveguide is injected with an amount of the electric current that is based on a resistance of a corresponding resistor of the plurality of resistors. Thus, by controlling an amount of electric current injection into each longitudinal section of the active waveguide, the super-broadband optical spectrum profile of the SLED can be configured to match with the requirements of various applications.

In some embodiments, the plurality of resistors are arranged in a parallel configuration in the resistance array, and each resistor of the plurality of resistors is associated with a corresponding longitudinal section of the plurality of longitudinal sections of the active waveguide.

In some embodiments, the SLED further comprises a substrate, a current blocking structure, a p-cladding layer, a p-metallization layer, and a passivation dielectric layer. The active waveguide is formed on the substrate. The current blocking structure is grown on the substrate and each side of the active waveguide. The p-cladding layer is grown on top of the active waveguide and the current blocking structure. The p-metallization layer is grown on top of the p-cladding layer. The resistance array is formed on top of the p-metallization layer. The passivation dielectric layer is deposited on top of the p-cladding layer and each side of the p-metallization layer. The single continuous contact pad is formed on the passivation dielectric layer and the resistance array.

In some embodiments, each resistor of the plurality of resistors has a different width with respect to other resistors of the plurality of resistors.

In some embodiments, each resistor of the plurality of resistors has a different thickness with respect to other resistors of the plurality of resistors.

In some embodiments, each resistor of the plurality of resistors has a different width and a different thickness with respect to other resistors of the plurality of resistors.

In some embodiments, the plurality of resistors are formed from titanium, nickel, and chromium.

In some embodiments, a design of a load line of the resistance array is a distributed design of the plurality of resistors.

In some embodiments, a design of a load line of the resistance array is a lumped design of the plurality of resistors.

In some embodiments, to form the active waveguide, a mask having a first stripe and a second stripe is patterned on a substrate.

In some embodiments, the first stripe and the second stripe of the mask are trapezoidal in shape. Further, a width of the first stripe decreases from a first end of the first stripe to a second end of the first stripe, and a width of the second stripe decreases from a first end of the second stripe to a second end of the second stripe.

In some embodiments, the first stripe and the second stripe are separated by a first gap that is constant.

In some embodiments, the active waveguide is formed in the first gap between the first stripe and the second stripe. A thickness of the active waveguide is greater at a rear end of the active waveguide with respect to a thickness at a front end of the active waveguide. The rear end of the active waveguide is formed by the first end of the first stripe and the first end of the second stripe, and the front end of the active waveguide is formed by the second end of the first stripe and the second end of the second stripe.

In some embodiments, a width of the first stripe decreases from a first end of the first stripe to a second end of the first stripe, and a width of the first stripe increases or decreases from the second end of the first stripe to a third end of the first stripe. A width of the second stripe decreases from a first end of the second stripe to a second end of the second stripe, and a width of the second stripe increases or decreases from the second end of the second stripe to a third end of the second stripe.

In some embodiments, a first gap between the first and second ends of the first stripe and the second stripe is a constant gap, and a second gap between the second and third ends of the first stripe and the second stripe is a varying gap.

In some embodiments, the active waveguide is formed in the first gap and the second gap between the first stripe and the second stripe, such that (i) a thickness of the active waveguide that is formed in the first gap, decreases from a rear end of the active waveguide to an intermediary end of the active waveguide and (ii) a thickness of the active waveguide that is formed in the second gap, increases or decreases from the intermediary end of the active waveguide to a front end of the active waveguide. The active waveguide formed in the second gap acts as a mode size converter to couple an external device to the SLED.

In some embodiments, a rear end of the active waveguide has a lower bandgap with respect to a front end of the active waveguide.

In some embodiments, the SLED further comprises feed-in connections that couple the resistance array with the single continuous contact pad.

In some embodiments, the active waveguide comprises a set of quantum wells and a pair of Separate Confinement Heterostructure (SCH) layers. The set of quantum wells are sandwiched between the pair of SCH layers. Based on the electric current injected in the active waveguide, each quantum well of the set of quantum wells emits light of a corresponding wavelength and optical power. The superluminescent broadband light is emitted by combination of the light emitted at each corresponding wavelength.

In some embodiments, the active waveguide suppresses back reflection of the superluminescent broadband light.

### BRIEF DESCRIPTION OF THE DRAWINGS

The accompanying drawings illustrate various embodiments of systems, methods, and other aspects of the disclosure. It will be apparent to a person skilled in the art that the illustrated element boundaries (e.g., boxes, groups of boxes, or other shapes) in the figures represent one example of the boundaries. In some examples, one element may be designed as multiple elements, or multiple elements may be designed as one element. In some examples, an element shown as an internal component of one element may be implemented as an external component in another, and vice versa.

Various embodiments of the present disclosure are illustrated by way of example, and not limited by the appended figures, in which like references indicate similar elements, and in which:
FIG. 1 shows a front view illustrating a superluminescent light emitting diode (SLED), in accordance with an embodiment of the present disclosure;
FIG. 2 illustrates a front view of a substrate and a dielectric mask that is patterned on the substrate of the SLED of FIG. 1, in accordance with an embodiment of the present disclosure;
FIG. 3 illustrates a three-dimensional (3-D) view of the substrate and the dielectric mask of FIG. 2, in accordance with one embodiment of the present disclosure;
FIG. 4 illustrates another 3-D view of the substrate and the dielectric mask of FIG. 2, in accordance with another embodiment of the present disclosure;
FIG. 5 illustrates a front view of the substrate and an active waveguide of the SLED of FIG. 1, in accordance with an embodiment of the present disclosure;
FIG. 6 illustrates a top view of the dielectric mask of FIG. 3, in accordance with an embodiment of the present disclosure;
FIG. 7 illustrates a 3-D view of the substrate and the active waveguide of FIG. 5, in accordance with an embodiment of the present disclosure;
FIG. 8 illustrates another 3-D view of the substrate and the active waveguide of FIG. 5, in accordance with another embodiment of the present disclosure;
FIG. 9 illustrates a front view of the substrate, the active waveguide, and a mesa etch mask patterned on the active waveguide of FIG. 5, in accordance with an embodiment of the present disclosure;
FIG. 10 illustrates a front view of the substrate, the active waveguide, the mesa etch mask, and a current blocking structure of the SLED of FIG. 1, in accordance with an embodiment of the present disclosure;
FIG. 11 illustrates a front view of the substrate, the active waveguide, the current blocking structure, and a p-cladding layer of the SLED of FIG. 1, in accordance with an embodiment of the present disclosure;
FIG. 12 illustrates a front view of the substrate, the active waveguide, the current blocking structure, the p-cladding layer, a p-metallization layer, and a passivation dielectric layer of the SLED of FIG. 1 in accordance with an embodiment of the present disclosure;
FIG. 13 illustrates a front view of the substrate, the active waveguide, the current blocking structure, the p-cladding layer, the p-metallization layer, the passivation dielectric layer, and a resistance array of the SLED of FIG. 1 in accordance with an embodiment of the present disclosure;
FIG. 14 illustrates a front view of the substrate, the active waveguide, the current blocking structure, the p-cladding layer, the p-metallization layer, the passivation dielectric layer, the resistance array, and a first single continuous contact pad of the SLED of FIG. 1 in accordance with an embodiment of the present disclosure;
FIG. 15 illustrates a top view of the resistance array, the first single continuous contact pad, and feed-in connections of the SLED of FIG. 1, in accordance with an embodiment of the present disclosure;
FIG. 16 illustrates a top view of the resistance array, the first single continuous contact pad, the p-metallization layer, and the feed-in connections of the SLED of FIG. 1, in accordance with another embodiment of the present disclosure;
FIGS. 17 and 18 illustrate a front view of the substrate, the active waveguide, the current blocking structure, the p-cladding layer, the p-metallization layer, the passivation dielectric layer, the resistance array, and the first single continuous contact pad of the SLED of FIG. 1 in accordance with an embodiment of the present disclosure;
FIG. 19A illustrates a top view of the resistance array, the first single continuous contact pad, and feed-in connections of the SLED of FIG. 1, in accordance with another embodiment of the present disclosure;
FIG. 19B illustrates a front view of a cross-section of the top view of the resistance array, the single continuous p-contact pad, and the feed-in connections of the SLED of FIG. 19A, in accordance with another embodiment of the present disclosure;
FIG. 19C illustrates a front view of another cross-section of the top view of the resistance array, the single continuous p-contact pad, and the feed-in connections of the SLED of FIG. 19A, in accordance with another embodiment of the present disclosure;
FIG. 20 illustrates a circuit diagram of the SLED of FIG. 1 in accordance with an embodiment of the present disclosure;
FIG. 21 is a graph that illustrates varying bandgap of the active waveguide of the SLED of FIG. 1 to realize super broadband continuous spectrum of the SLED, in accordance with an embodiment of the present disclosure;
FIG. 22 is a graph that illustrates a combination of multiple optical spectrum of the emitted light from the active waveguide to achieve the super broadband continuous spectrum of an optical bandwidth of the SLED of FIG. 1, in accordance with an embodiment of the present disclosure; and
FIGS. 23A and 23B illustrate a flowchart that illustrates a method of fabrication of the SLED of FIG. 1, in accordance with an embodiment of the present disclosure.

Further areas of applicability of the present disclosure will become apparent from the detailed description provided hereinafter. It should be understood that the detailed description of exemplary embodiments is intended for illustration purposes only and is, therefore, not intended to necessarily limit the scope of the present disclosure.

### DETAILED DESCRIPTION

The present disclosure is best understood with reference to the detailed figures and description set forth herein. Various embodiments are discussed below with reference to the figures. However, those skilled in the art will readily appreciate that the detailed description given herein with respect to the figures are simply for explanatory purposes as the methods and systems may extend beyond the described embodiments. In one example, the teachings presented and the needs of a particular application may yield multiple alternate and suitable approaches to implement the functionality of any detail described herein. Therefore, any approach may extend beyond the particular implementation choices in the following embodiments that are described and shown.

A "semiconductor" as used herein and throughout this disclosure refers to, but is not limited to, a material having an electrical conductivity falling between that of a conductor and an insulator. The material may be an elemental material or a compound material. A semiconductor may include, but not be limited to, an element, a binary alloy, a tertiary alloy, and a quaternary alloy. Structures formed using a semiconductor or semiconductors may comprise a single semiconductor material, two or more semiconductor materials, a semiconductor alloy of a single composition, a semiconductor alloy of two or more discrete compositions, and a semiconductor alloy graded from a first semiconductor alloy to a second semiconductor alloy. A semiconductor may be one of undoped (intrinsic), p-type doped, n-type doped, graded in doping from a first doping level of one type to a second doping level of the same type, and graded in doping from a first doping level of one type to a second doping level of a different type. Semiconductors may include, but are not limited to III-V semiconductors, such as those between aluminum (Al), gallium (Ga), and indium (In) with arsenic (As), and phosphorus (P), including for example Gallium Arsenide (GaAs), Gallium Phosphide (GaP), Indium Phosphide (InP), Indium Arsenide (InAs), Indium Gallium Arsenide (InGaAs), Indium Gallium Arsenide Phosphide (InGaAsP) and Indium Aluminum Gallium Arsenide (InAlGaAs).

A "substrate" as used herein and throughout this disclosure refers to, but is not limited to, a surface upon which semiconductor structures, such as an active waveguide and embodiments of the disclosure may be formed. This may include, but not be limited to, InP and GaAs or a combination thereof.

A "metal" as used herein and throughout this disclosure refers to, but is not limited to, a material (element, compound, and alloy) that has good electrical and thermal conductivity as a result of readily losing outer shell electrons. This may include, but not be limited to, gold, chromium, aluminum, silver, platinum, nickel, copper, rhodium, palladium, tungsten, and combinations of such materials.

An "electrode", "contact", "track", "trace", or "terminal" as used herein and throughout this disclosure refers to, but is not limited to, a material having good electrical conductivity and that is optically opaque. This includes structures formed from thin films, thick films, and plated films for example of materials including, but not limited to, metals such as gold, chromium, aluminum, silver, platinum, nickel, copper, rhodium, palladium, tungsten, and combinations of such materials. Other electrode configurations may employ combinations of metals, for example, a chromium adhesion layer and a gold electrode layer.

Bandgap as used herein and throughout this disclosure refers to, but is not limited to, an energy level in the semiconductor materials, such that the energy is emitted when an electron transitions from a conduction band to a valence band, or the energy required by an electron for transition from the valence band to a conduction band.

Super-broadband continuous spectrum as used herein and throughout this disclosure refers to, but is not limited to, a spectrum of light with an optical bandwidth of 100 nanometers and beyond. Super-broadband spectrum is achieved by an active waveguide of the present disclosure that has a varying bandgap along a length of the active waveguide. As each discrete bandgap contributes to a specific optical gain profile, the varying bandgap of the active waveguide enables a combined super-broad optical bandwidth that is achieved by the convolution of several optical gain profiles emitted from the active waveguide.

Active waveguide as used herein and throughout this disclosure refers to, but is not limited to, a structure that guides the photons which are emitted in that structure. In one embodiment, the active waveguide has a varying bandgap that increases from a rear end of the active waveguide to a front end of the active waveguide and the thickness of the active waveguide decreases from the rear end of the active waveguide to the front end. In another embodiment, the active waveguide has a varying bandgap that increases from the rear end to an intermediary end of the active waveguide and increases or decreases from the intermediary end to the front end and the thickness of the active waveguide decreases from the rear end to the intermediary end of the active waveguide and increases or decreases from the intermediary end to the front end. The active waveguide includes multi-quantum wells (MQW). The active waveguide may be formed from materials including, but not limited to, undoped indium gallium arsenide phosphide (InGaAsP), undoped indium aluminum gallium arsenide (InAlGaAs), and undoped indium gallium arsenide (InGaAs).

Separate confinement heterostructure (SCH) layers as used herein and throughout this disclosure refers to, but are not limited to, a pair of layers that sandwiches quantum well layers of the active waveguide. The SCH layers have a lower refractive index than the quantum well layers and provide vertical optical confinement to the SLED. The SCH layers may be formed from materials including, but not limited to, undoped indium gallium arsenide phosphide (InGaAsP), undoped indium aluminum gallium arsenide (InAlGaAs), and undoped indium gallium arsenide (InGaAs).

Dielectric mask as used herein and throughout this disclosure refers to, but is not limited to, cross-hatched trapezoidal patterned dielectric stripes of varying width from one end to another end of both the stripes. This dielectric mask may be formed from materials including but not limited to, silicon dioxide (SiO₂), silicon nitride (SiN), and silicon oxynitride (SiON).

Selective area epitaxy (SAE) as used herein and throughout this disclosure refers to, but is not limited to, a growth of an active waveguide in a gap between two cross-hatched trapezoidal patterned dielectric stripes of the dielectric mask. The two dielectric stripes have varying widths from one end to another end. The techniques used to achieve SAE may include, but are not limited to, molecular beam epitaxy (MBE), metalorganic vapor phase epitaxy (MOVPE), and chemical beam epitaxy (CBE).

References to "an embodiment", "another embodiment", "yet another embodiment", "one example", "another example", "yet another example", "for example" and so on, indicate that the embodiment(s) or example(s) so described may include a particular feature, structure, characteristic, property, element, or limitation, but that not every embodiment or example necessarily includes that particular feature, structure, characteristic, property, element or limitation. Furthermore, repeated use of the phrase "in an embodiment" does not necessarily refer to the same embodiment.

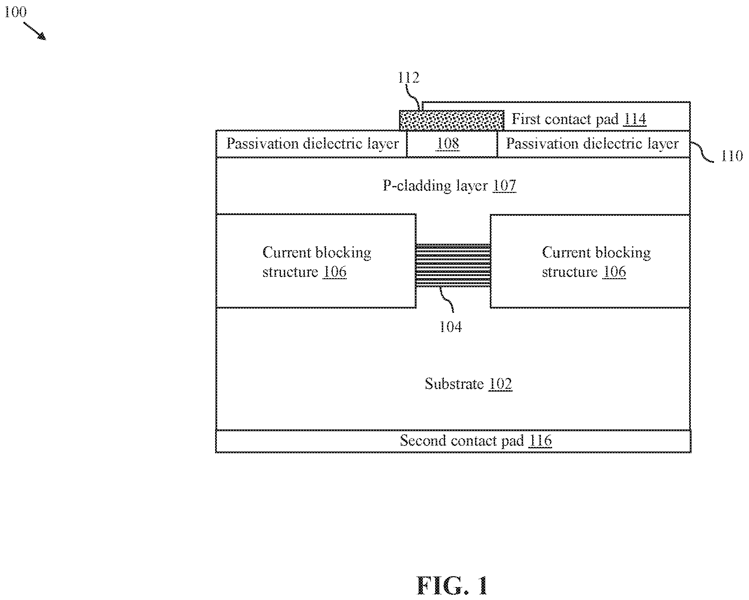

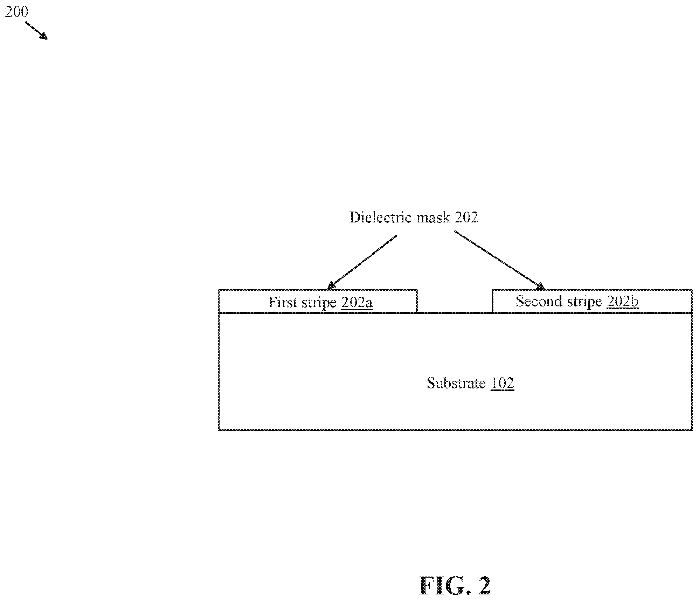

Referring now to FIG. 1, a front view illustrating a superluminescent light emitting diode (SLED) 100, in accordance with an embodiment of the present disclosure is shown. The SLED 100 is a semiconductor light source. The SLED 100 emits super-broadband continuous spectrum incoherent light. Thus, the SLED 100 is also referred to as a super-broadband continuous spectrum SLED 100. The SLED 100 includes a substrate 102 and a series of layers 104-116 formed on the substrate 102. The series of layers 104-116 includes an active waveguide 104, a current blocking structure 106, a p-cladding layer 107, a p-metallization layer 108, a passivation dielectric layer 110, a resistance array 112, a first contact pad 114, and a second contact pad 116. The first contact pad 114 is also referred to as a "first single continuous contact pad 114". In an embodiment, the first single continuous contact pad 114 is a p-contact pad, and the second contact pad 116 is an n-contact pad. The layout and function of the abovementioned series of layers 104-116 as well as the fabrication of the SLED 100 is explained in conjunction with FIGS. 2-15.

Referring now to FIGS. 2-15, steps for fabricating the SLED 100, in accordance with an embodiment of the present disclosure, are shown. FIG. 2 illustrates a front view 200 of the substrate 102 and a dielectric mask 202 that is patterned on the substrate 102, in accordance with an embodiment of the present disclosure. The substrate 102 may be formed from various materials. Examples of such materials include semiconductor materials; such as indium phosphide (InP) and gallium arsenide (GaAs) or a combination thereof.

The dielectric mask 202 includes a first stripe 202a and a second stripe 202b that are patterned on the substrate 102. To pattern the dielectric mask 202, an oxide layer may be grown on the substrate 102 using a thin film deposition technique such as chemical vapor deposition (CVD) or physical vapor deposition (PVD), or another suitable deposition technique. The oxide layer grown on the substrate 102 is patterned using photolithography and etching to form the first stripe 202a and the second stripe 202b of the dielectric mask 202. The dielectric mask 202 may be formed from various materials. Examples of such materials may include, but are not limited to silicon dioxide (SiO₂), silicon nitride (SiN), and silicon oxynitride (SiON). Although in the present embodiment, the dielectric mask 202 is dielectric, it will be apparent to a person skilled in the art that in various other embodiments, the dielectric mask 202 can be made of any suitable material such as glass or metal.

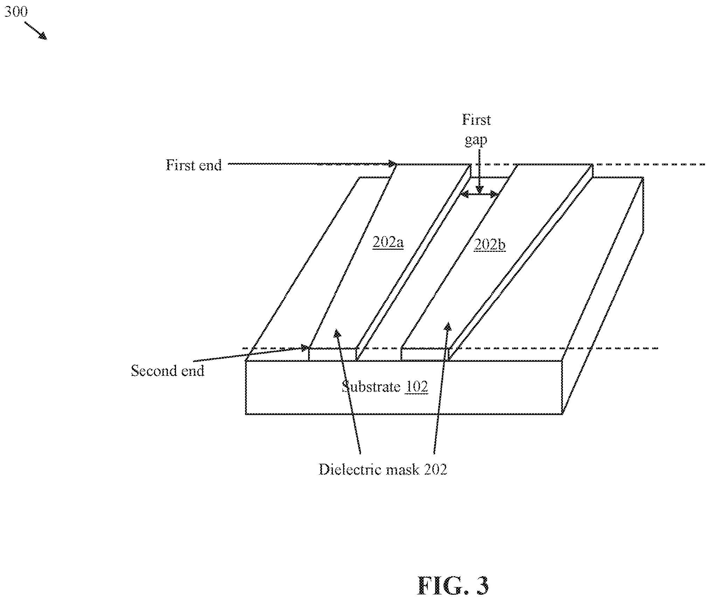

FIG. 3 illustrates a three-dimensional (3-D) view 300 of the substrate 102 and the dielectric mask 202, in accordance with one embodiment of the present disclosure. The first stripe 202a and the second stripe 202b are trapezoidal in shape. In an embodiment, the first stripe 202a and the second stripe 202b of the dielectric mask 202 are of varying widths such that a width of the first stripe 202a decreases from a first end of the first stripe 202a to a second end of the first stripe 202a, and a width of the second stripe 202b decreases from a first end of the second stripe 202b to a second end of the second stripe 202b. In an embodiment, the first end of the first stripe 202a and the first end of the second stripe 202b form a first end of the dielectric mask 202. Further, the second end of the first stripe 202a and the second end of the second stripe 202b form a second end of the dielectric mask 202. The first stripe 202a and the second stripe 202b are separated by a first gap that is constant throughout between the first stripe 202a and the second stripe 202b. It will be understood by a person skilled in the art that the first and second ends designated in FIG. 3 are merely used for simplicity of visualizing the ends and are not restrictive to the stated ends or the marked ends in FIG. 3.

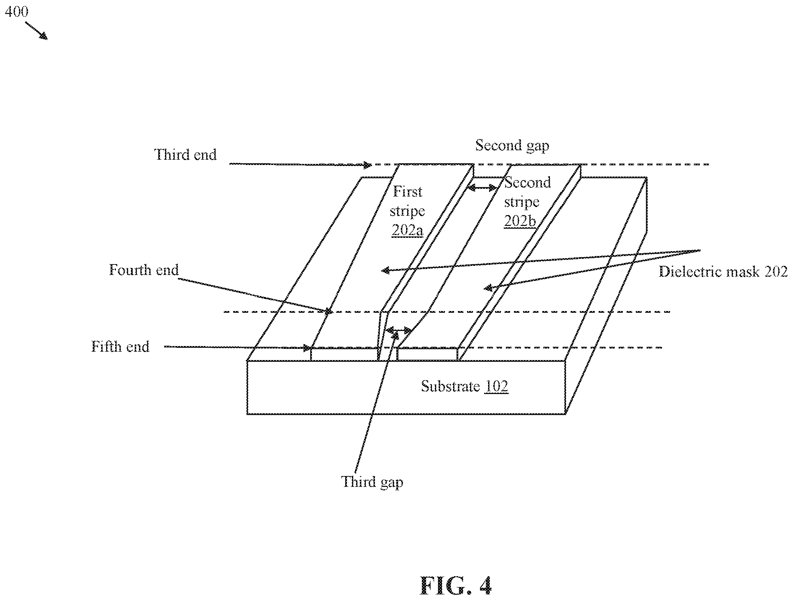

FIG. 4 illustrates another 3-D view 400 of the substrate 102 and the dielectric mask 202, in accordance with another embodiment of the present disclosure. A width of the first stripe 202a decreases from a third end of the first stripe 202a to a fourth end of the first stripe 202a and a width of the first stripe 202a increases or decreases from the fourth end of the first stripe 202a to a fifth end of the first stripe 202a. A width of the second stripe 202b decreases from a third end of the second stripe 202b to a fourth end of the second stripe 202b and a width of the second stripe 202b increases or decreases from the fourth end of the second stripe 202b to a fifth end of the second stripe 202b. In an embodiment, the third end of the first stripe 202a and the third end of the second stripe 202b form a third end of the dielectric mask 202. Further, the fourth end of the first stripe 202a and the fourth end of the second stripe 202b form a fourth end of the dielectric mask 202. Additionally, the fifth end of the first stripe 202a and the fifth end of the second stripe 202b form a fifth end of the dielectric mask 202. A shape of the first stripe 202a from the third end to the fourth end is trapezoidal. Further, a shape of the first stripe 202a from the fourth end to the fifth end is trapezoidal. Similarly, a shape of the second stripe 202b from the third end to the fourth end is trapezoidal and a shape of the second stripe 202b from the fourth end to the fifth end is trapezoidal. The first stripe 202a and the second stripe 202b are separated by a second gap and a third gap such that the second gap between the third end and the fourth end of each of the first stripe 202a and the second stripe 202b is constant. Further, the third gap between the fourth end and the fifth end of each of the first stripe 202a and the second stripe 202b is variable. It will be understood by a person skilled in the art that the third end, the fourth end, and the fifth end designated in FIG. 4 are merely used for simplicity of visualizing the ends and are not restrictive to the stated ends in FIG. 4.

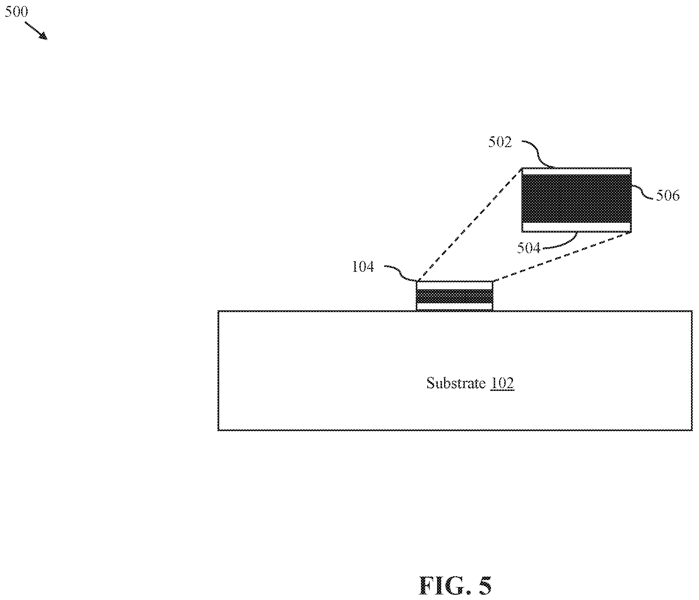

FIG. 5 illustrates a front view 500 of the substrate 102 and the active waveguide 104, in accordance with an embodiment of the present disclosure. In one embodiment, the active waveguide 104 is grown in the first gap with respect to FIG. 3. In another embodiment, the active waveguide 104 is grown in the second gap and the third gap with respect to FIG. 4. In an example, the first gap is formed between a right section of the first stripe 202a and the left section of the second stripe 202b with respect to FIG. 3. Similarly, the second gap and the third gap are formed between a right section of the first stripe 202a and the left section of the second stripe 202b with respect to FIG. 4. For the sake of simplicity, layers at a left section of the first stripe 202a and a right section of the second stripe 202b are excluded from FIG. 5.

In an embodiment, the active waveguide 104 includes a pair of Separate Confinement Heterostructure (SCH) layers 502 and 504 and a set of quantum wells 506. The set of quantum wells 506 is sandwiched between the pair of SCH layers 502 and 504. The active waveguide 104 is formed using thin film deposition techniques such as MBE, MOVPE, CBE, or a combination thereof. To grow the active waveguide 104, a first SCH layer 502 is grown on the substrate 102. Each quantum well of the set of quantum wells 506 are grown one after the other on the first SCH layer 502. In an embodiment, a barrier layer (not shown) is included between each quantum well of the set of quantum wells 506. A second SCH layer 504 is grown on the set of quantum wells 506. The active waveguide 104 has a continuously varying bandgap. The active waveguide 104 is divided into a plurality of longitudinal sections such that a front section of the plurality of longitudinal sections has a higher bandgap with respect to a rear section of the plurality of longitudinal sections. After the active waveguide 104 is formed on the substrate 102, the dielectric mask 202 is etched from the substrate 102 by an etching process such as wet etching, plasma etching that includes but is not limited to reactive ion etching and deep reactive ion etching, sputter etching, or a combination thereof.

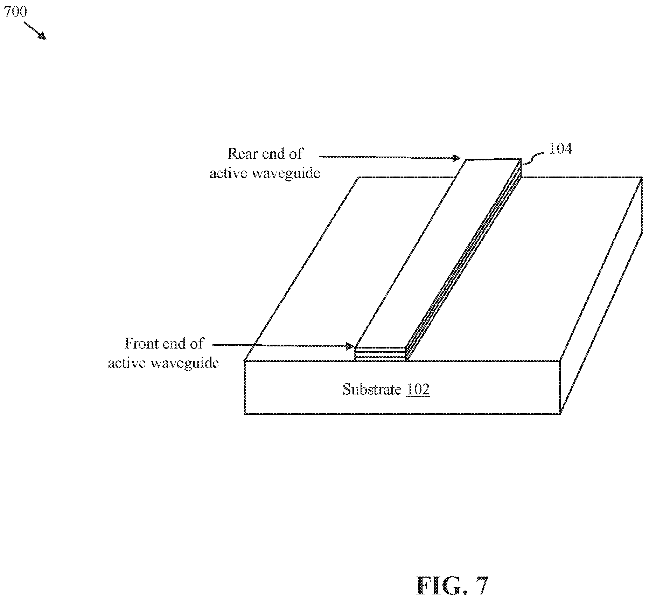

In one embodiment with respect to FIG. 3, when the active waveguide 104 is formed in the first gap between the first stripe 202a and the second stripe 202b, a thickness of the active waveguide 104 is greater at a rear end of the active waveguide 104 with respect to a thickness at a front end of the active waveguide 104. The rear end of the active waveguide 104 is formed by the first end of the first stripe 202a and the first end of the second stripe 202b. The front end of the active waveguide 104 is formed by the second end of the first stripe 202a and the second end of the second stripe 202b. The active waveguide 104 that is formed in the first gap is depicted in FIG. 7.

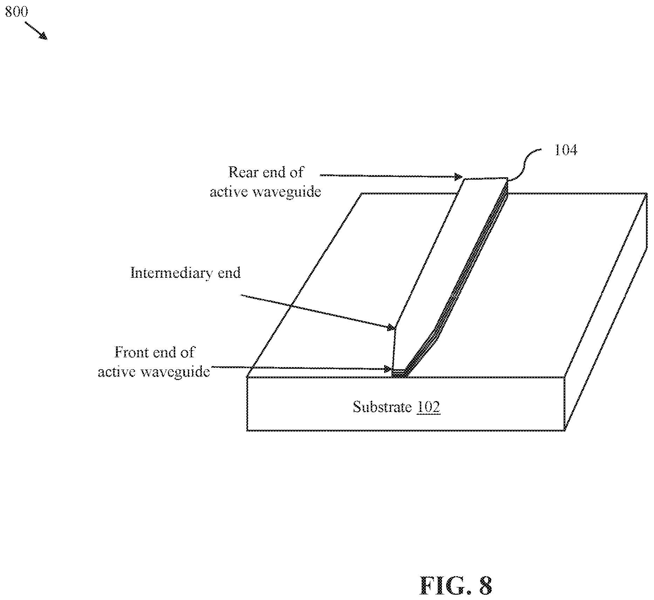

In another embodiment with respect to FIG. 4, when the active waveguide 104 is formed in the second gap and the third gap between the first stripe 202a and the second stripe 202b, a thickness of the active waveguide 104 is greater at a rear end of the active waveguide 104 with respect to a thickness at a front end of the active waveguide 104. The rear end of the active waveguide 104 is formed due to the third end of the first stripe 202a and the third end of the second stripe 202b. The front end of the active waveguide 104 is formed due to the fifth end of the first stripe 202a and the fifth end of the second stripe 202b. The thickness of the active waveguide 104 decreases from a rear end to an intermediary end of the active waveguide 104 and increases from the intermediary end to a front end of the active waveguide 104. The intermediary end of the active waveguide 104 is formed due to the fourth end of the first stripe 202a and the fourth end of the second stripe 202b. In yet another embodiment, the thickness of the active waveguide 104 decreases from the intermediary end to a front end of the active waveguide 104. The active waveguide 104 that is formed in the second gap and the third gap is depicted in FIG. 8.

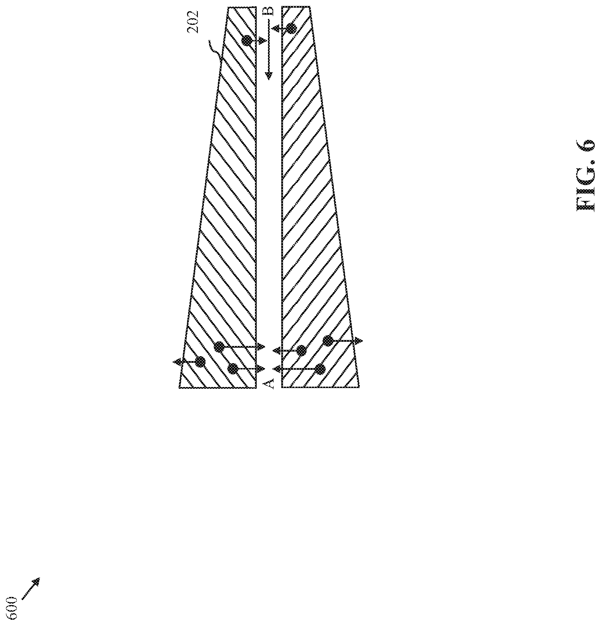

FIG. 6 illustrates a top view 600 of the dielectric mask 202, in accordance with an embodiment of the present disclosure. The top view 600 of the dielectric mask 202 is with respect to FIG. 3. Further, the top view of the first stripe 202a and the second stripe 202b with respect to FIG. 4 is not shown and will be understood by a person skilled in the art. The active waveguide 104 has a varying thickness due to a difference in the growth rate of the active waveguide 104 along a longitudinal section of the active waveguide 104. The difference in the growth rate is due to the varying width of the first stripe 202a and the second stripe 202b of the dielectric mask 202. A wider width of the first stripe 202a and the second stripe 202b results in a faster growth rate of the active waveguide 104 that is adjacent to the wider width and grown in corresponding portions of one of (i) the first gap with respect to FIG. 3 and (ii) the second and third gaps with respect to FIG. 4. Further, a narrower width of the first stripe 202a and the second stripe 202b results in a slower growth rate of the active waveguide 104 that is adjacent to the narrower width and grown in corresponding portions of one of (i) the first gap with respect to FIG. 3 and (ii) the second and third gaps with respect to FIG. 4. The faster growth rate results in a growth of thick layer of the active waveguide 104 whereas the slower growth rate results in the growth of comparatively thin layer of the active waveguide 104.

During the SAE process, atoms of the material for forming the active waveguide 104 that land on the dielectric mask 202 and migrate to an edge of the dielectric mask 202 contribute to the growth of the active waveguide 104 in one of (i) the first gap with respect to FIG. 3 and (ii) the second and third gaps with respect to FIG. 4. In an example, a mask width of a first region of the first stripe 202a and the second stripe 202b is larger than a mask width of a second region of the first stripe 202a and the second stripe 202b. Thus, a large number of atoms migrate to the first region (shown as 'A' in FIG. 6) of the dielectric mask 202 and comparatively a smaller number of atoms migrate to a second region (shown as 'B' in FIG. 6) of the dielectric mask 202. Due to the migration of a large number of atoms in the first region, a thicker growth of the active waveguide 104 is formed in a first portion that is defined by the first region of one of the (i) first gap with respect to FIG. 3 and (ii) second and third gaps with respect to FIG. 4 as compared to a second portion that is defined by the second region of one of the (i) first gap and (ii) second and third gaps. A thick quantum well layer of the active waveguide 104 has a smaller bandgap in comparison to a thin quantum well layer of active waveguide 104 which has a larger bandgap as will be understood by a person skilled in the art. Thus, a continuously varying bandgap of the active waveguide 104 is obtained.

FIG. 7 illustrates a 3-D view 700 of the substrate 102 and the active waveguide 104, in accordance with an embodiment of the present disclosure. In the embodiment, the active waveguide 104 is formed in the first gap between the first stripe 202a and the second stripe 202b. The active waveguide 104 is grown in the first gap by a process of SAE as explained above. The active waveguide 104 has a continuously varying bandgap as explained in FIG. 6. The rear end of the active waveguide 104 is thick with respect to the front end of the active waveguide 104. Thus, the rear end of the active waveguide 104 has a lower bandgap with respect to the front end of the active waveguide 104.

FIG. 8 illustrates another 3-D view 800 of the substrate 102 and the active waveguide 104, in accordance with another embodiment of the present disclosure. The active waveguide 104 is formed in the second gap and the third gap between the first stripe 202a and the second stripe 202b of FIG. 4. In an embodiment, the active waveguide 104 has a varying bandgap that increases from the rear end to an intermediary end of the active waveguide 104 and increases or decreases from the intermediary end to the front end of the active waveguide 104. Further, the thickness of the active waveguide 104 decreases from the rear end to the intermediary end of the active waveguide 104 and increases or decreases from the intermediary end to the front end of the active waveguide 104. Such a formation of the active waveguide 104 results in the active waveguide 104 having a 3-dimensional (D) taper formed at the front end of the active waveguide 104. The front end of the active waveguide 104 thus acts as a mode size converter that facilitates efficient coupling of super broadband incoherent light emitted by the SLED 100 to a receiving waveguide (not shown) or an optical fiber (not shown). It will be apparent to a person skilled in the art that in another embodiment, the rear end of the active waveguide 104 can be configured as a mode size converter. The rear end of the active waveguide 104 is thick with respect to the front end of the active waveguide 104. Thus, the rear end of the active waveguide 104 has a lower bandgap with respect to the front end of the active waveguide 104. It will be apparent to a person skilled in the art that in various other embodiments, the rear end and the front end of the active waveguide 104 are reversed to accordingly vary the direction of propagation of light.

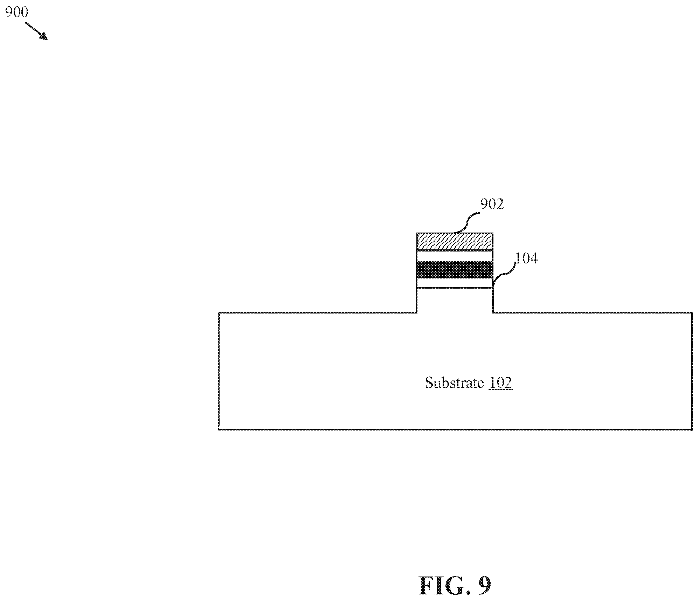

FIG. 9 illustrates a front view 900 of the substrate 102, the active waveguide 104, and a mesa etch mask 902, in accordance with an embodiment of the present disclosure. The mesa etch mask 902 is formed on top of the active waveguide 104 by one of patterning a photoresist on top of the active waveguide 104, thin film deposition techniques, or a combination thereof and will be apparent to a person skilled in the art. The mesa etch mask 902 prevents a formation of the current blocking structure 106 on the active waveguide 104.

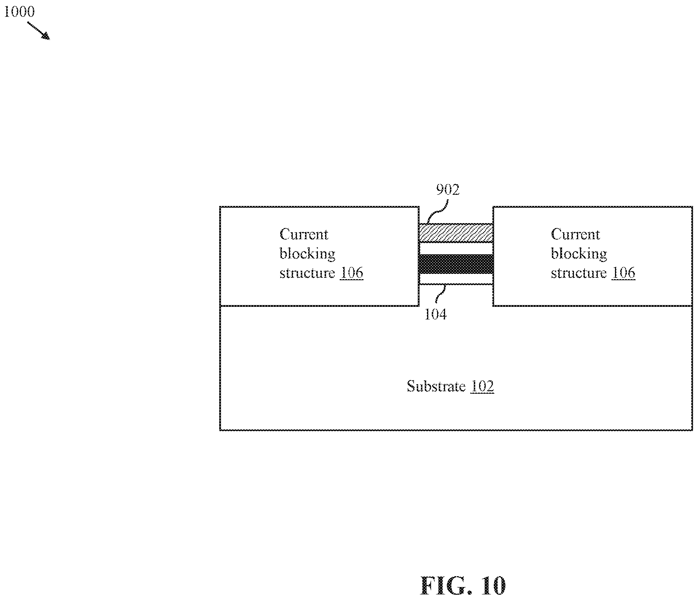

FIG. 10 illustrates a front view 1000 of the substrate 102, the active waveguide 104, the mesa etch mask 902, and the current blocking structure 106, in accordance with an embodiment of the present disclosure. The current blocking structure 106 is formed on the substrate 102 by thin film epitaxial growth techniques. The current blocking structure 106 prevents a flow of leakage current from the active waveguide 104 into the current blocking structure 106 and provides optical confinement of light emitted by the longitudinal portions of the active waveguide 104. In an embodiment, the current blocking structure 106 is formed from materials including, but not limited to, semi-insulating InP such as Fe-doped InP, or Positive-Negative-Positive (PNP) doped InP, that is p-InP/n-InP. The mesa etch mask 902 is etched after the formation of the current blocking structure 106. The etching of the mesa etch mask 902 may occur by suitable wet and dry etching techniques.

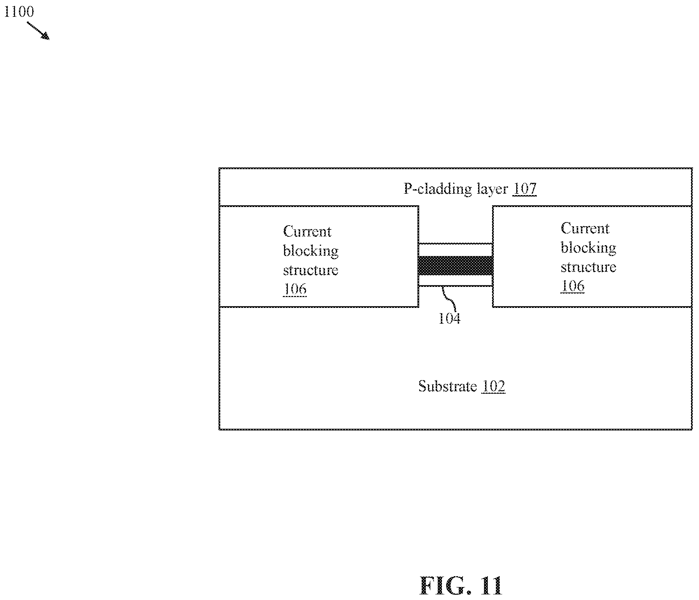

FIG. 11 illustrates a front view 1100 of the substrate 102, the active waveguide 104, the current blocking structure 106, and the p-cladding layer 107, in accordance with an embodiment of the present disclosure. The p-cladding layer 107 is formed on the active waveguide 104 and the current blocking structure 106 by thin film epitaxial growth techniques as will be apparent to a person skilled in the art. The p-cladding layer 107 is formed with InP. Zinc (Zn) or carbon (C) may be used in the p-cladding layer 107. The p-cladding layer 107 offers a low refractive index to the emitted light by the active waveguide 104 and low resistance to the injected current. The injected current passes by way of the p-cladding layer 107 which further injects holes into the active waveguide 104.

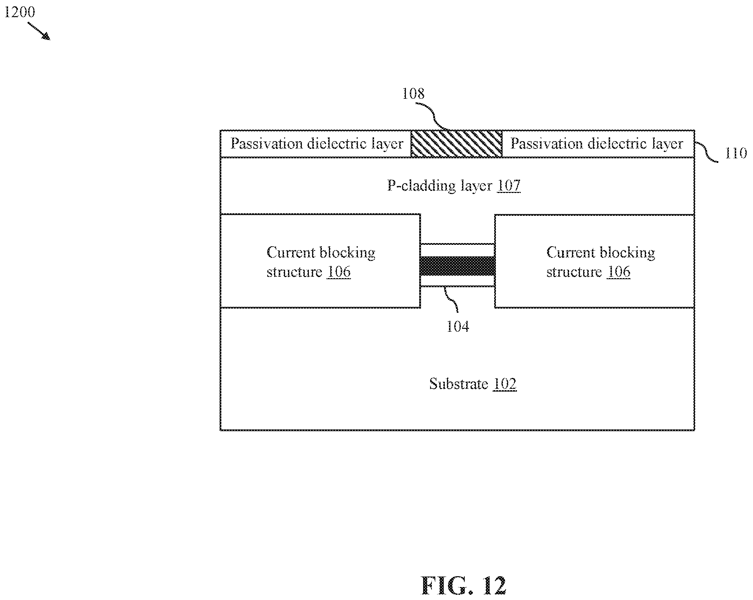

FIG. 12 illustrates a front view 1200 of the substrate 102, the active waveguide 104, the current blocking structure 106, the p-cladding layer 107, the p-metallization layer 108, and the passivation dielectric layer 110 in accordance with an embodiment of the present disclosure. The passivation dielectric layer 110 is formed on the p-cladding layer 107 above the current blocking structure 106 by chemical vapor deposition. The passivation dielectric layer 110 is formed such that it directs the injected current to flow through the p-metallization layer 108. The passivation dielectric layer 110 may be formed from various materials. Examples of such materials include silicon oxide, silicon nitride, and silicon oxynitride. The p-metallization layer 108 is formed on the p-cladding layer 107 by a process of thin film deposition as will be understood by a person skilled in the art. The p-metallization layer 108 has very low resistance and directs the current flow towards the active waveguide 104 when the current is injected from the first single continuous contact pad 114 by way of the resistance array 112. The material of the p-metallization layer 108 is selected from Gold (Au), Titanium (Ti), Platinum (Pt), or a combination thereof.

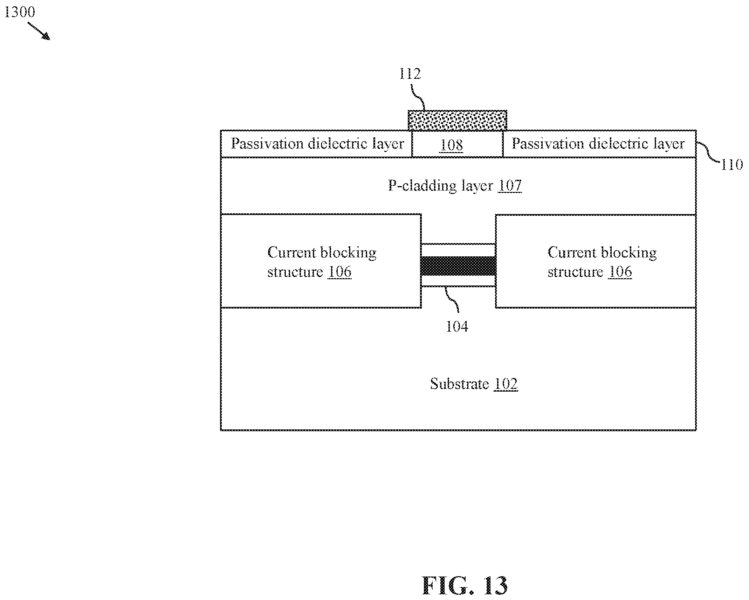

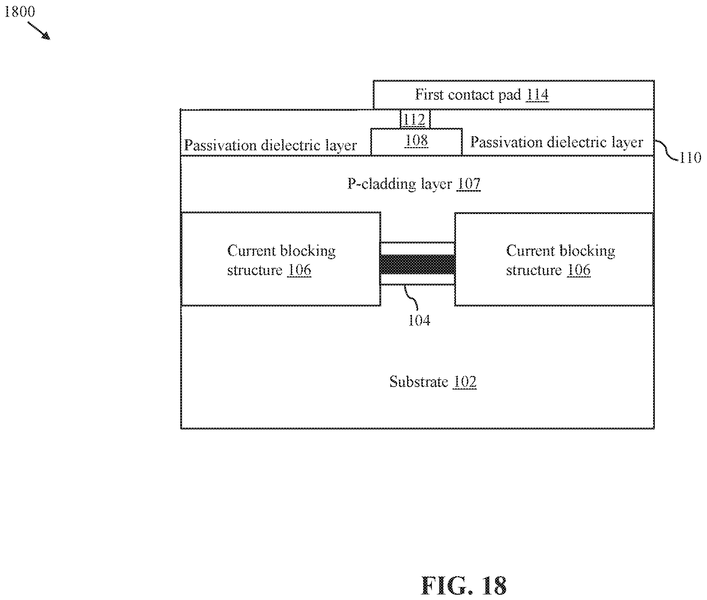

FIG. 13 illustrates a front view 1300 of the substrate 102, the active waveguide 104, the current blocking structure 106, the p-cladding layer 107, the p-metallization layer 108, the passivation dielectric layer 110, and the resistance array 112 in accordance with an embodiment of the present disclosure. The resistance array 112 is a thin film resistance array that is formed on the p-metallization layer 108 using thin film deposition techniques such as electron beam evaporation, sputter deposition, CVD, or a combination thereof. The resistance array 112 includes a plurality of resistors (shown later in FIG. 18). The plurality of resistors of the resistance array 112 may be formed from various materials. Examples of such materials include titanium, nickel, and chromium. In an embodiment, the plurality of resistors are arranged in a parallel configuration in the resistance array 112.

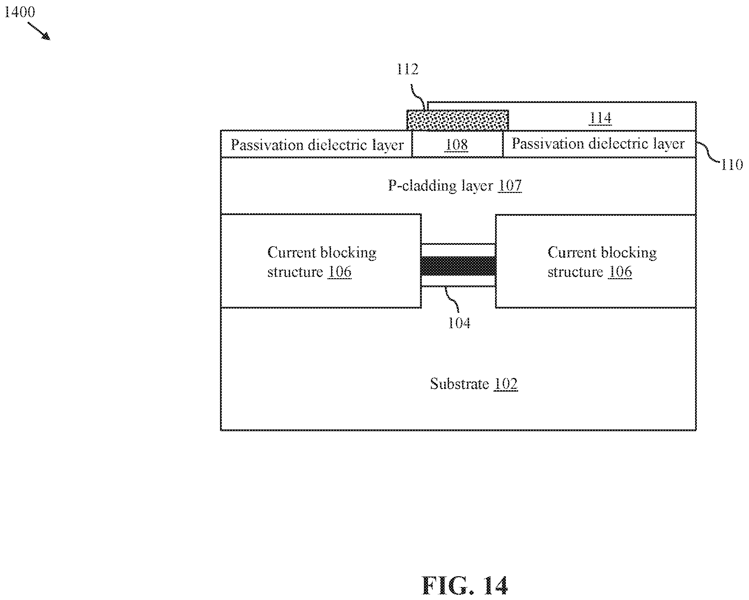

FIG. 14 illustrates a front view 1400 of the substrate 102, the active waveguide 104, the current blocking structure 106, the p-cladding layer 107, the p-metallization layer 108, the passivation dielectric layer 110, the resistance array 112, and the first single continuous contact pad 114 in accordance with an embodiment of the present disclosure. The first single continuous contact pad 114 is formed by a suitable thin film deposition technique on a first region of the resistance array 112 and a first region of the passivation dielectric layer 110 whereas a second region of the resistance array 112 and a second region of the passivation dielectric layer 110 is left uncoated with the material of the first single continuous contact pad 114. The second contact pad 116 is further formed below the substrate 102 and the SLED 100 as depicted in FIG. 1. It will be apparent to a person skilled in the art the thickness and doping of each layer of the set of layers 104-116 is based on applications of the SLED 100.

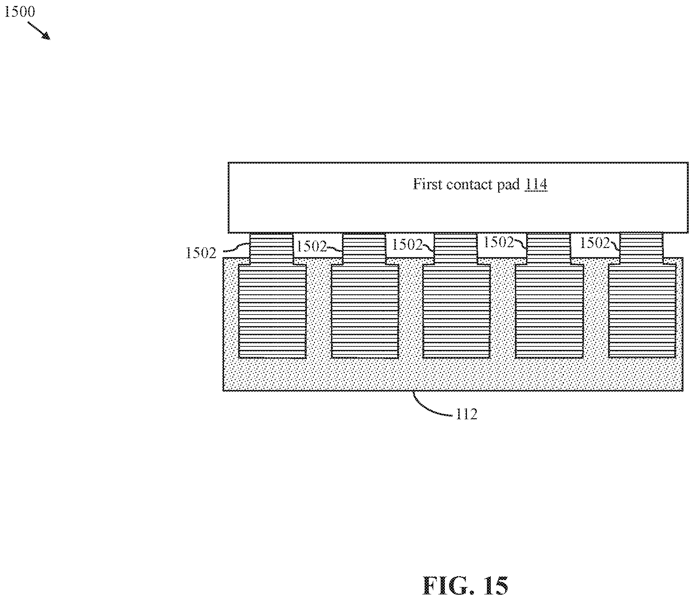

FIG. 15 illustrates a top view 1500 of the resistance array 112, the first single continuous contact pad 114, and feed-in connections 1502, in accordance with an embodiment of the present disclosure. The resistance array 112 is coupled with the first single continuous contact pad 114 by the feed-in connections 1502. In the embodiment of FIG. 15, a design of a load line of the resistance array 112 is a distributed design of the plurality of resistors.

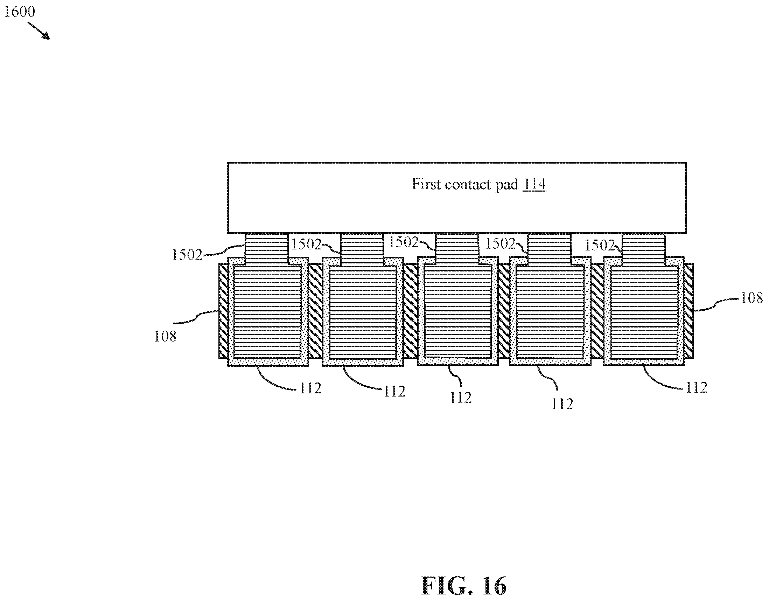

FIG. 16 illustrates a top view 1600 of the resistance array 112, the first single continuous contact pad 114, the p-metallization layer 108, and the feed-in connections 1502, in accordance with another embodiment of the present disclosure. The feed-in connections 1502 couple the resistance array 112 with the first single continuous contact pad 114. In the embodiment of FIG. 16, a design of a load line of the resistance array 112 is a lumped design of the plurality of resistors such that although the arrangement of plurality of resistors is discrete, the p-metallization layer 108 on top of the active waveguide 104 is continuous and hence will not lead to an abrupt discontinuity in the effective continuous refractive index of the active waveguide 104 between adjacent lumped resistors of the plurality of resistors.

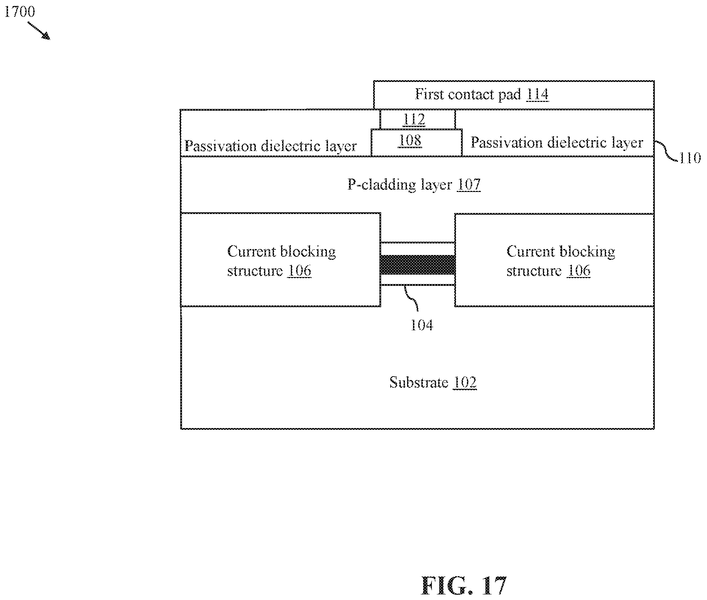

FIGS. 17 and 18 illustrate a front view 1700 and 1800 of the substrate 102, the active waveguide 104, the current blocking structure 106, the p-cladding layer 107, the p-metallization layer 108, the passivation dielectric layer 110, the resistance array 112, and the first single continuous contact pad 114 in accordance with another embodiment of the present disclosure. A resistance value of the resistance array 112 is determined based on a cross-sectional area of the resistance array 112 such that a smaller cross-sectional area results in a larger lumped resistance value whereas a larger cross-sectional area results in a smaller lumped resistance value. In addition, the passivation dielectric layer 110 is grown up to a height of the resistance array 112 such that the first contact pad 114 directly contacts both the first and second regions of the passivation dielectric layer 110. Further, a cross sectional area of the resistance array 112 of FIG. 17 is larger as compared to a cross sectional area of the resistance array 112 of FIG. 18. Thus, the resistance value of the resistance array 112 of FIG. 17 is smaller due to the larger cross-sectional area of the resistance array 112 of FIG. 17 as compared to the resistance value of the resistance array 112 of FIG. 18.

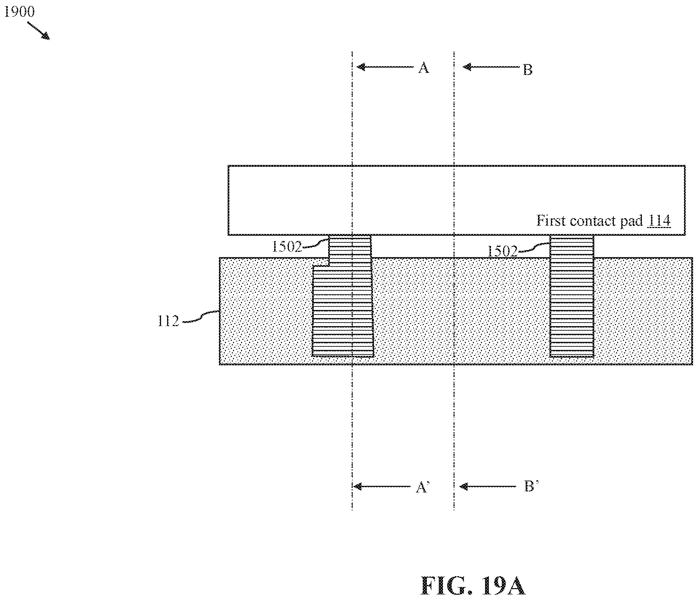

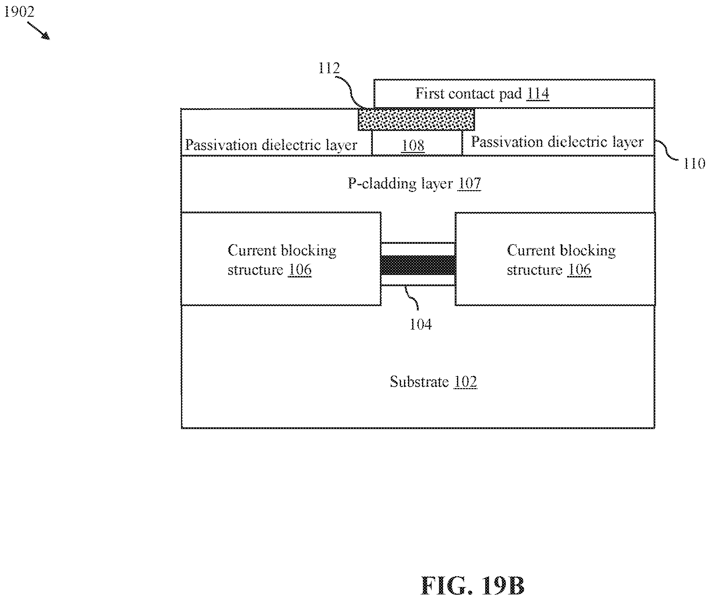

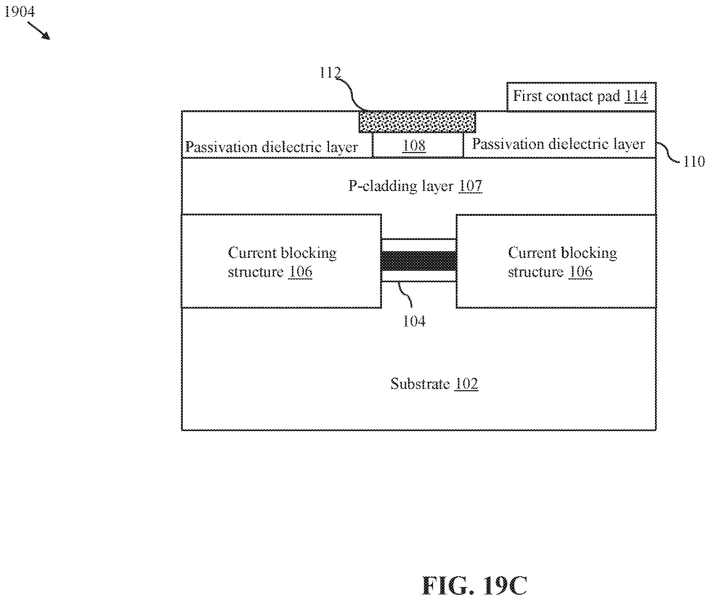

FIG. 19A illustrates a top view 1900 of the resistance array 112, the first single continuous contact pad 114, and the feed-in connections 1502, in accordance with another embodiment of the present disclosure. The first single continuous contact pad 114 is connected to the resistance array 112 by the feed-in connections 1502. A number of the feed-in connections 1502 is two as compared to five feed-in connections 1502 that are depicted in FIG. 15. In addition, a shape of the two feed-in connections 1502 of FIG. 19A are different as compared to shapes of the feed-in connections 1502 of FIG. 15. The resistance array 112 is divided into two sections that are depicted by cross-sections A-A' and B-B'. Further the cross-section A-A' is shown in FIG. 19B and the cross-section B-B' is shown in FIG. 19C.

FIG. 19B illustrates a front view of a cross-section A-A' of the top view of the resistance array 112, the first single continuous contact pad 114, and the feed-in connections 1502 of the SLED 100 in accordance with another embodiment of the present disclosure. FIG. 19B further illustrates a front view 1902 of the substrate 102, the active waveguide 104, the current blocking structure 106, the p-cladding layer 107, the p-metallization layer 108, and the passivation dielectric layer 110.

FIG. 19C illustrates a front view of a cross-section B-B' of the top view of the resistance array 112, the first single continuous contact pad 114, and the feed-in connections 1502 of the SLED 100 in accordance with another embodiment of the present disclosure. FIG. 19C further illustrates a front view 1904 of the substrate 102, the active waveguide 104, the current blocking structure 106, the p-cladding layer 107, the p-metallization layer 108, and the passivation dielectric layer 110.

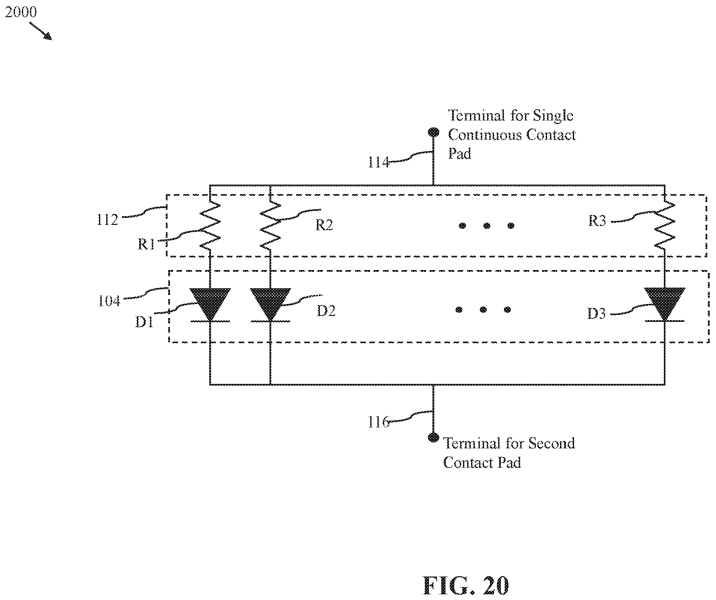

FIG. 20 illustrates a circuit diagram 2000 of the SLED 100 in accordance with an embodiment of the present disclosure. The circuit diagram 2000 of the SLED 100 depicts a terminal of the first single continuous contact pad 114, a terminal of the second contact pad 116, a plurality of resistors R1, R2,...., and R3 that are arranged in a parallel configuration, and a plurality of SLEDs D1, D2,...., D3. As the active waveguide 104 is divided into the plurality of longitudinal sections each longitudinal section is associated with a corresponding SLED such as a first SLED D1, a second SLED D2, and a third SLED D3. Further, each longitudinal section of the plurality of longitudinal sections of the active waveguide 104 is injected with an amount of the electric current that is based on a resistance value of a corresponding resistor of the plurality of resistors R1, R2,...., and R3 that is associated with a corresponding longitudinal section of the plurality of longitudinal sections of the active waveguide 104. In an example, the plurality of longitudinal sections include a first longitudinal section, a second longitudinal section, and a third longitudinal section. Further, the plurality of resistors include a first resistor R1, a second resistor R2, and a third resistor R3. The first resistor R1 is associated with the first SLED D1 corresponding to the first longitudinal section. The second resistor R2 is associated with the second SLED D2 corresponding to the second longitudinal section. The third resistor R3 is associated with the third SLED D3 corresponding to the third longitudinal section.

In operation of the SLED 100, a potential difference is applied between the terminal of the first single continuous contact pad 114 and the terminal of the second contact pad 116. Due to the applied potential difference, holes from the first single continuous contact pad 114 and electrons from the second contact pad 116 travel towards the active waveguide 104 which results in current injection into the active waveguide 104 by the way of the resistance array 112 through the p-metallization layer 108 and the p-cladding layer 107. Each resistor of the plurality of resistors R1, R2,...., and R3 has a different value of resistance from each other for achieving a desired current that is to be injected in a corresponding longitudinal section of the active waveguide 104. Thus, each longitudinal section of the plurality of longitudinal sections of the active waveguide 104 is injected with an amount of the electric current that is based on the resistance of a corresponding resistor of the plurality of resistors R1, R2,...., and R3. In an example, a first current, a second current, and a third current flows through the first longitudinal section, the second longitudinal section, and the third longitudinal section due to resistance of the first resistor R1, the second resistor R2, and the third resistor R3, respectively. Based on the injected current in each longitudinal section and a bandgap in the corresponding longitudinal section, light of corresponding wavelength and optical power is emitted by each quantum well from the corresponding longitudinal section, *i.e.,* by each of the first SLED D1, the second SLED D2, and the third SLED D3. In an example, the first longitudinal section emits light at a first wavelength of 1300 nm, the second longitudinal section emits light at a second wavelength of 1301 nm, and the remaining sections of the active waveguide 104 emit light of wavelengths up to and beyond 1400 nm. A combination of the emitted light at each corresponding wavelength from all the corresponding longitudinal sections results in the superluminescent broadband light emitted by the SLED 100.

The varying value of resistances of the plurality of resistors R1, R2,...., and R3 are achieved by designing the resistance array 112 as explained herein. In one embodiment, each resistor of the plurality of resistors R1, R2,...., and R3 is designed with a different width with respect to other resistors of the plurality of resistors R1, R2,...., and R3. In another embodiment, each resistor of the plurality of resistors R1, R2,...., and R3 is designed with a different thickness with respect to other resistors of the plurality of resistors R1, R2,...., and R3. In yet another embodiment, each resistor of the plurality of resistors R1, R2,...., and R3 is designed with a different width and a different thickness with respect to other resistors of the plurality of resistors R1, R2,...., and R3.

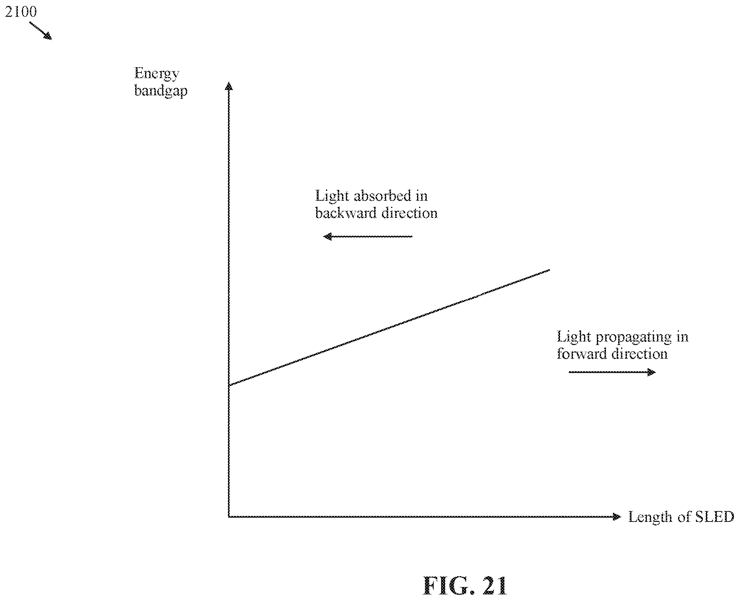

FIG. 21 is a graph 2100 that illustrates the varying bandgap of the active waveguide 104 to realize super broadband continuous spectrum of the SLED 100, in accordance with an embodiment of the present disclosure. The graph 2100 shows the energy bandgap along a Y-axis varying along a length of the active waveguide 104 along an X-axis. The SLED 100 includes the active waveguide 104 that has a continuously varying bandgap. The bandgap varies along the direction of propagation of the light within the SLED 100. In other words, the bandgap varies from a smaller bandgap energy to a larger bandgap energy in a forward output light propagating direction *(i.e.,* light propagating in the forward direction). As the bandgap of light varies from the smaller bandgap to the larger bandgap in the direction of propagation of light, the forward propagating light is not absorbed by the larger bandgap section of the active waveguide 104. Conversely, any backward propagating light is absorbed by the smaller bandgap section in the backward direction of the light, referred to as light absorbed in backward direction in FIG. 21. Hence, any residue or spurious back reflected light from the rear end of the active waveguide 104 is suppressed, thereby achieving a very low spectral ripple by the SLED 100.

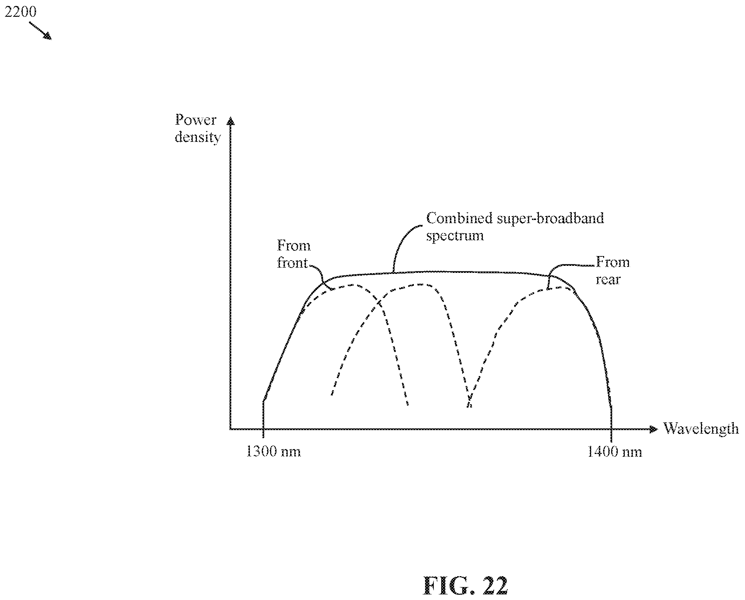

FIG. 22 is a graph 2200 that illustrates a combination of multiple optical spectrum of the emitted light from the active waveguide 114 to achieve the super broadband continuous spectrum of the optical bandwidth of the SLED 100, in accordance with an embodiment of the present disclosure. The Y-axis depicts power density of the SLED 100 and X-axis designates wavelength (example 1300 nm to 1400 nm) of the emitted light from each longitudinal section. As each discrete bandgap of light contributes to a specific optical gain profile, *i.e.,* varying energy transmitted by the varying bandgap of the active waveguide 104, the varying bandgap structure enables a combined super-broad optical bandwidth (1300 nm - 1400 nm) as shown in the graph 2200. The combined super-broad optical bandwidth is achieved by the convolution of many specific composition optical gain profiles. Based on the current injected that is pre-determined by the resistance array 112, different optical power from each longitudinal section of the active waveguide 104 is achieved thereby achieving super broadband continuous spectrum of the optical bandwidth of the SLED 100. Further, the continuous optical spectrum profile of the optical bandwidth can be designed to be flat-top, Gaussian, Lorentzian or any other required spectrum profile.

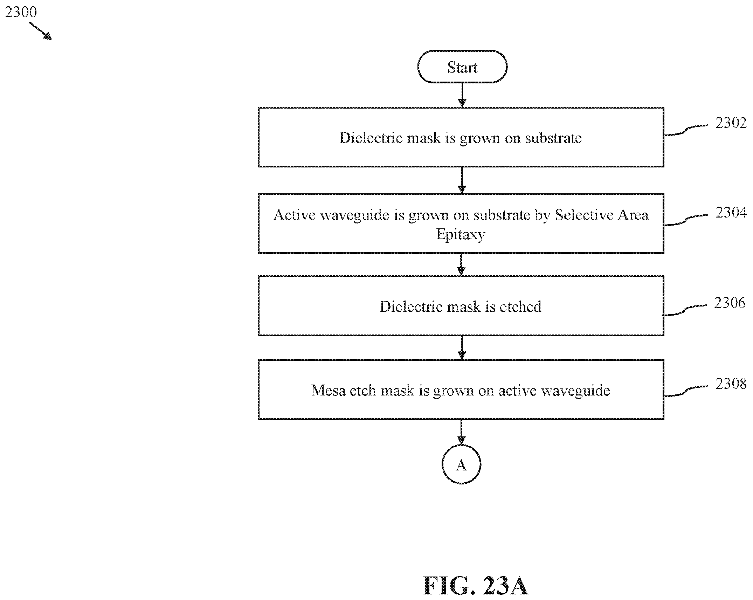

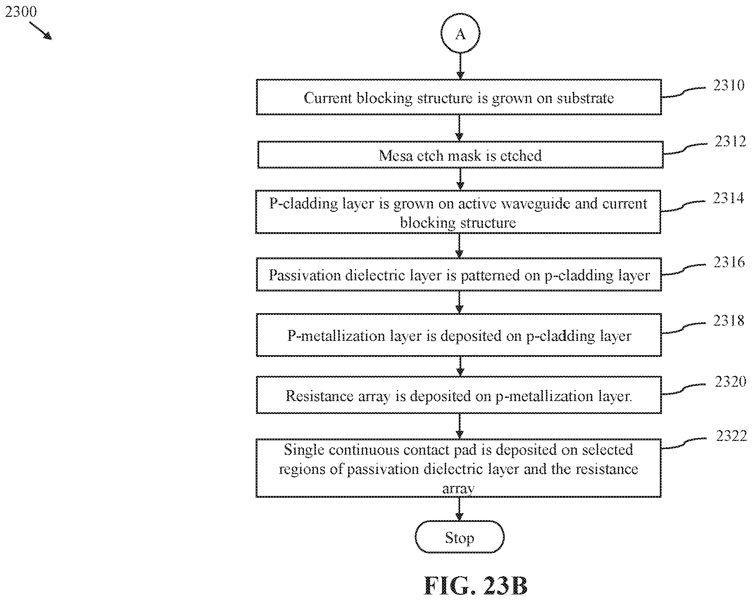

FIGS. 23A and 23B illustrate a flowchart 2300 that illustrates a method of fabrication of the SLED 100, in accordance with an embodiment of the present disclosure. At step 2302, the dielectric mask 202 is grown on the substrate 102 by thin film deposition techniques. At step 2304, the active waveguide 104 is grown between the first stripe 202a and the second stripe 202b on the substrate 102 by selective area epitaxy process. The active waveguide 104 is grown in (i) the first gap or (ii) the second gap and the third gap. At step 2306, the dielectric mask 202 is etched from the substrate 102. At step 2308, the mesa etch mask 902 is grown on the active waveguide 104 to form the current blocking structure 106 on the substrate 102. At step 2310, the current blocking structure 106 is grown on the substrate 102 excluding the active waveguide 104. At step 2312, the mesa etch mask 902 is etched from top of the active waveguide 104. At step 2314, the p-cladding layer 107 is grown on the active waveguide 104 and the current blocking structure 106. At step 2316, the passivation dielectric layer 110 is patterned on the p-cladding layer 107. At step 2318, the p-metallization layer 108 is deposited on the p-cladding layer 107. At step 2320, the resistance array 112 is deposited on top of the p-metallization layer 108. At step 2322, the first single continuous contact pad 114 is deposited on selected region of the passivation dielectric layer 110 and the resistance array 112.

Thus, the SLED 100 fabricated by methods as explained in the foregoing, results in a super broad optical bandwidth of incoherent light, *i.e.,* the super broadband continuous spectrum of the incoherent light. The SLED 100 has a very low spectral ripple in comparison to conventional SLED due to back reflection light suppression of the superluminescent broadband light in the SLED 100. The design of the SLED 100 also has an advantage of better optical coupling to a receiving waveguide in comparison to the conventional SLED due to a formation of 3-D taper during the process of fabrication which acts as a mode size converter for the SLED 100. The SLED 100 find its application in photonics sensing like optical coherence tomography. Further, the SLED 100 deploys a single contact pad as the first electrode, *i.e.,* the first single continuous contact pad 114 and eliminates the need for multiple electrodes for injecting varying currents at different longitudinal sections of the active waveguide 104 to realize the required optical gain profile. Further, the active waveguide 104 is grown using selective area epitaxy thereby reducing multiple process steps for fabricating the active waveguide 104.

In the claims, the words 'comprising', 'including' and 'having' do not exclude the presence of other elements or steps then those listed in a claim. The terms "a" or "an," as used herein, are defined as one or more than one. Unless stated otherwise, terms such as "first" and "second" are used to arbitrarily distinguish between the elements such terms describe. Thus, these terms are not necessarily intended to indicate temporal or other prioritization of such elements. The fact that certain measures are recited in mutually different claims does not indicate that a combination of these measures cannot be used to advantage.

While various exemplary embodiments of the disclosed system and method have been described above it should be understood that they have been presented for purposes of example only, not limitations. However, the invention is defined by the appended claims.

## Claims

1. A super luminescent light emitting diode (SLED) (100) comprising:
a single continuous contact pad (114) that is configured as an electrode:
a resistance array (112) coupled with the single continuous contact pad (114) and comprising a plurality of resistors; and
an active waveguide (104) that has a varying bandgap and is divided into a plurality of longitudinal sections, wherein the active waveguide (104) is configured to emit a superluminescent broadband light based on the varying bandgap and an electric current injected in the active waveguide, wherein the electric current is injected in the active waveguide (104) by the single continuous contact pad (114) by way of the resistance array (112), and wherein each longitudinal section of the plurality of longitudinal sections of the active waveguide is injected with an amount of the electric current that is based on a resistance of a corresponding resistor of the plurality of resistors.

2. The SLED of claim 1, wherein the plurality of resistors are arranged in a parallel configuration in the resistance array, and wherein each resistor of the plurality of resistors is associated with a corresponding longitudinal section of the plurality of longitudinal sections of the active waveguide.

3. The SLED of claim 1, further comprising:
a substrate, wherein the active waveguide is formed on the substrate;
a current blocking structure grown on the substrate and each side of the active waveguide;
a p-cladding layer grown on top of the active waveguide and the current blocking structure;
a p-metallization layer grown on top of the p-cladding layer, wherein the resistance array is formed on top of the p-metallization layer; and
a passivation dielectric layer deposited on top of the p-cladding layer and each side of the p-metallization layer, wherein the single continuous contact pad is formed on the passivation dielectric layer and the resistance array.

4. The SLED of claim 1, wherein each resistor of the plurality of resistors has a different width with respect to other resistors of the plurality of resistors.

5. The SLED of claim 1, wherein each resistor of the plurality of resistors has a different thickness with respect to other resistors of the plurality of resistors.

6. The SLED of claim 1, wherein each resistor of the plurality of resistors has a different width and a different thickness with respect to other resistors of the plurality of resistors.

7. The SLED of claim 1, wherein the plurality of resistors are formed from titanium, nickel, and chromium.

8. The SLED of claim 1, wherein a design of a load line of the resistance array is a distributed design of the plurality of resistors.

9. The SLED of claim 1, wherein a design of a load line of the resistance array is a lumped design of the plurality of resistors.

10. The SLED of claim 1, wherein to form the active waveguide, a mask having a first stripe and a second stripe is patterned on a substrate.

11. The SLED of claim 10, wherein the first stripe and the second stripe of the mask are trapezoidal in shape, and wherein a width of the first stripe decreases from a first end of the first stripe to a second end of the first stripe, and a width of the second stripe decreases from a first end of the second stripe to a second end of the second stripe.

12. The SLED of claim 11, wherein the first stripe and the second stripe are separated by a first gap that is constant.

13. The SLED of claim 12, wherein the active waveguide is formed in the first gap between the first stripe and the second stripe, wherein a thickness of the active waveguide is greater at a rear end of the active waveguide with respect to a thickness at a front end of the active waveguide, and wherein the rear end of the active waveguide is formed by the first end of the first stripe and the first end of the second stripe, and the front end of the active waveguide is formed by the second end of the first stripe and the second end of the second stripe.

14. The SLED of claim 10, wherein a width of the first stripe decreases from a first end of the first stripe to a second end of the first stripe, and a width of the first stripe increases or decreases from the second end of the first stripe to a third end of the first stripe, and wherein a width of the second stripe decreases from a first end of the second stripe to a second end of the second stripe, and a width of the second stripe increases or decreases from the second end of the second stripe to a third end of the second stripe.

15. The SLED of claim 14, wherein a first gap between the first and second ends of the first stripe and the second stripe is a constant gap, and a second gap between the second and third ends of the first stripe and the second stripe is a varying gap.

16. The SLED of claim 15, wherein the active waveguide is formed in the first gap and the second gap between the first stripe and the second stripe, wherein (i) a thickness of the active waveguide that is formed in the first gap, decreases from a rear end of the active waveguide to an intermediary end of the active waveguide and (ii) a thickness of the active waveguide that is formed in the second gap, increases or decreases from the intermediary end to a front end of the active waveguide, and wherein the active waveguide formed in the second gap acts as a mode size converter to couple an external device to the SLED.

17. The SLED of claim 1, wherein a rear end of the active waveguide has a lower bandgap with respect to a front end of the active waveguide

18. The SLED of claim 1, further comprising feed-in connections that couple the resistance array with the single continuous contact pad.

19. The SLED of claim 1, wherein the active waveguide comprises:
a set of quantum wells; and
a pair of Separate Confinement Heterostructure (SCH) layers, wherein the set of quantum wells are sandwiched between the pair of SCH layers, wherein based on the electric current injected in the active waveguide, each quantum well of the set of quantum wells emits light of a corresponding wavelength and optical power, and wherein the superluminescent broadband light is emitted by a combination of the light emitted at each corresponding wavelength.

20. The SLED of claim 1, wherein the active waveguide suppresses back reflection of the superluminescent broadband light.

## Patentansprüche

1. - Superlumineszenzdiode (SLED) (100), umfassend:
eine einzelne durchgehende Kontaktfläche (114), die als Elektrode konfiguriert ist:
eine Widerstandsanordnung (112), die mit der einzelnen durchgehenden Kontaktfläche (114) gekoppelt ist und eine Vielzahl von Widerständen umfasst; und
einen aktiven Wellenleiter (104), der eine variierende Bandlücke aufweist und in eine Vielzahl von Längsabschnitten unterteilt ist, wobei der aktive Wellenleiter (104) konfiguriert ist, um basierend auf der variierenden Bandlücke und einem in den aktiven Wellenleiter eingeleiteten elektrischen Strom ein Superlumineszenz-Breitbandlicht zu emittieren, wobei der elektrische Strom durch die einzelne durchgehende Kontaktfläche (114) über die Widerstandsanordnung (112) in den aktiven Wellenleiter (104) eingeleitet wird,
und wobei in jeden Längsabschnitt der Vielzahl von Längsabschnitten des aktiven Wellenleiters eine Menge des elektrischen Stroms eingeleitet wird, die auf einem Widerstand eines entsprechenden Widerstands der Vielzahl von Widerständen basiert.

2. - SLED nach Anspruch 1, wobei die Vielzahl von Widerständen in einer parallelen Konfiguration in der Widerstandsanordnung angeordnet sind, und wobei jeder Widerstand der Vielzahl von Widerständen mit einem entsprechenden Längsabschnitt der Vielzahl von Längsabschnitten des aktiven Wellenleiters assoziiert ist.

3. - SLED nach Anspruch 1, ferner umfassend:
ein Substrat, wobei der aktive Wellenleiter auf dem Substrat gebildet ist;
eine stromsperrende Struktur, die auf dem Substrat und auf jeder Seite des aktiven Wellenleiters gewachsen ist;
eine p-Mantelschicht, die auf der Oberseite des aktiven Wellenleiters und der stromsperrenden Struktur gewachsen ist;
eine p-Metallisierungsschicht, die auf der Oberseite der p-Mantelschicht gewachsen ist, wobei die Widerstandsanordnung auf der Oberseite der p-Metallisierungsschicht gebildet ist; und
eine dielektrische Passivierungsschicht, die auf der Oberseite der p-Mantelschicht und auf jeder Seite der p-Metallisierungsschicht aufgebracht ist, wobei die einzelne durchgehende Kontaktfläche auf der dielektrischen Passivierungsschicht und der Widerstandsanordnung gebildet ist.

4. - SLED nach Anspruch 1, wobei jeder Widerstand der Vielzahl von Widerständen eine unterschiedliche Breite in Bezug auf die anderen Widerstände der Vielzahl von Widerständen aufweist.

5. - SLED nach Anspruch 1, wobei jeder Widerstand der Vielzahl von Widerständen eine unterschiedliche Stärke in Bezug auf die anderen Widerstände der Vielzahl von Widerständen aufweist.

6. - SLED nach Anspruch 1, wobei jeder Widerstand der Vielzahl von Widerständen eine unterschiedliche Breite und eine unterschiedliche Stärke in Bezug auf die anderen Widerstände der Vielzahl von Widerständen aufweist.

7. - SLED nach Anspruch 1, wobei die Vielzahl der Widerstände aus Titan, Nickel und Chrom gebildet ist.

8. - SLED nach Anspruch 1, wobei eine Konstruktion einer Lastleitung der Widerstandsanordnung eine verteilte Konstruktion der Vielzahl von Widerständen ist.

9. - SLED nach Anspruch 1, wobei eine Konstruktion einer Lastleitung der Widerstandsanordnung eine konzentrierte Konstruktion der Vielzahl von Widerständen ist.

10. - SLED nach Anspruch 1, wobei zum Bilden des aktiven Wellenleiters eine Maske, die einen ersten Streifen und einen zweiten Streifen aufweist, auf ein Substrat gemustert wird.

11. - SLED nach Anspruch 10, wobei der erste Streifen und der zweite Streifen der Maske trapezförmig sind, und wobei eine Breite des ersten Streifens von einem ersten Ende des ersten Streifens zu einem zweiten Ende des ersten Streifens abnimmt, und eine Breite des zweiten Streifens von einem ersten Ende des zweiten Streifens zu einem zweiten Ende des zweiten Streifens abnimmt.

12. - SLED nach Anspruch 11, wobei der erste Streifen und der zweite Streifen durch eine erste Lücke getrennt sind, die konstant ist.

13. - SLED nach Anspruch 12, wobei der aktive Wellenleiter in der ersten Lücke zwischen dem ersten Streifen und dem zweiten Streifen gebildet ist, wobei eine Stärke des aktiven Wellenleiters an einem hinteren Ende des aktiven Wellenleiters größer ist als eine Stärke an einem vorderen Ende des aktiven Wellenleiters, und wobei das hintere Ende des aktiven Wellenleiters durch das erste Ende des ersten Streifens und das erste Ende des zweiten Streifens gebildet ist, und das vordere Ende des aktiven Wellenleiters durch das zweite Ende des ersten Streifens und das zweite Ende des zweiten Streifens gebildet ist.

14. - SLED nach Anspruch 10, wobei eine Breite des ersten Streifens von einem ersten Ende des ersten Streifens zu einem zweiten Ende des ersten Streifens abnimmt, und eine Breite des ersten Streifens von dem zweiten Ende des ersten Streifens zu einem dritten Ende des ersten Streifens zunimmt oder abnimmt, und wobei eine Breite des zweiten Streifens von einem ersten Ende des zweiten Streifens zu einem zweiten Ende des zweiten Streifens abnimmt, und eine Breite des zweiten Streifens von dem zweiten Ende des zweiten Streifens zu einem dritten Ende des zweiten Streifens zunimmt oder abnimmt.

15. - SLED nach Anspruch 14, wobei ein erster Spalt zwischen dem ersten und dem zweiten Ende des ersten Streifens und dem zweiten Streifen ein konstanter Spalt ist und ein zweiter Spalt zwischen dem zweiten und dem dritten Ende des ersten Streifens und dem zweiten Streifen ein variierender Spalt ist.

16. - SLED nach Anspruch 15, wobei der aktive Wellenleiter in der ersten Lücke und der zweiten Lücke zwischen dem ersten Streifen und dem zweiten Streifen gebildet ist, wobei (i) die Stärke des aktiven Wellenleiters, der in dem ersten Spalt gebildet ist, von einem hinteren Ende des aktiven Wellenleiters zu einem mittleren Ende des aktiven Wellenleiters abnimmt, und (ii) eine Stärke des aktiven Wellenleiters, die in dem zweiten Spalt gebildet ist, von dem mittleren Ende zu einem vorderen Ende des aktiven Wellenleiters zunimmt oder abnimmt, und wobei der in der zweiten Lücke gebildete aktive Wellenleiter als Modengrößenwandler wirkt, um eine externe Vorrichtung mit der SLED zu koppeln.

17. - SLED nach Anspruch 1, wobei ein hinteres Ende des aktiven Wellenleiters eine niedrigere Bandlücke aufweist als ein vorderes Ende des aktiven Wellenleiters.

18. - SLED nach Anspruch 1, ferner umfassend Einspeiseverbindungen, die die Widerstandsanordnung mit der einzelnen durchgehenden Kontaktfläche verbinden.

19. - SLED nach Anspruch 1, wobei der aktive Wellenleiter Folgendes umfasst:
einen Satz von Quantentöpfen; und
ein Paar Schichten einer Separate Confinement Heterostructure (SCH), wobei der Satz von Quantentöpfen zwischen das Paar von SCH-Schichten eingefügt ist, wobei basierend auf des in den aktiven Wellenleiter eingeleiteten elektrischen Stroms jeder Quantentopf des Satzes von Quantentöpfen Licht mit einer entsprechenden Wellenlänge und optischen Leistung emittiert, und wobei das Superlumineszenz-Breitbandlicht durch eine Kombination des bei jeder entsprechenden Wellenlänge emittierten Lichts emittiert wird.

20. - SLED nach Anspruch 1, wobei der aktive Wellenleiter eine Rückreflexion des Superlumineszenz-Breitbandlichts unterdrückt.

## Revendications

1. - Diode électroluminescente superluminescente (SLED) (100) comprenant :
un patin de contact continu unique (114) qui est configuré en tant qu'électrode ;
un réseau de résistances (112) couplé à l'unique patin de contact continu (114) et comprenant une pluralité de résistances ; et
un guide d'ondes actif (104) qui a une bande interdite variable et est divisé en une pluralité de sections longitudinales, le guide d'ondes actif (104) étant configuré pour émettre une lumière superluminescente à large bande basée sur la bande interdite variable et un courant électrique injecté dans le guide d'ondes actif, le courant électrique étant injecté dans le guide d'ondes actif (104) par le patin de contact continu unique (114) au moyen du réseau de résistances (112), et chaque section longitudinale de la pluralité de sections longitudinales du guide d'ondes actif étant injectée par une quantité du courant électrique qui est basée sur une résistance électrique d'une résistance correspondante de la pluralité de résistances.

2. - SLED selon de la revendication 1, dans laquelle les différentes résistances sont disposées dans une configuration parallèle dans le réseau de résistances, et dans laquelle chaque résistance de la pluralité de résistances est associée à une section longitudinale correspondante de la pluralité de sections longitudinales du guide d'ondes actif.

3. - SLED selon la revendication 1, comprenant en outre :
un substrat, le guide d'ondes actif étant formé sur le substrat ;
une structure de blocage de courant développée sur le substrat et de chaque côté du guide d'ondes actif ;
une couche de placage de type p, développée sur la partie supérieure du guide d'ondes actif et la structure de blocage du courant ;
une couche de métallisation de type p développée sur la partie supérieure de la couche de placage de type p, le réseau de résistances étant formé sur la partie supérieure de la couche de métallisation de type p ; et
une couche diélectrique de passivation déposée sur la partie supérieure de la couche de placage de type p et sur chaque côté de la couche de métallisation de type p, le patin de contact continu unique étant formé sur la couche diélectrique de passivation et sur le réseau de résistances.

4. - SLED selon la revendication 1, dans laquelle chaque résistance de la pluralité de résistances a une largeur différente par rapport aux autres résistances de la pluralité de résistances.

5. - SLED selon la revendication 1, dans laquelle chaque résistance de la pluralité de résistances a une épaisseur différente par rapport aux autres résistances de la pluralité de résistances.

6. - SLED selon la revendication 1, dans laquelle chaque résistance de la pluralité de résistances a une largeur différente et une épaisseur différente par rapport aux autres résistances de la pluralité de résistances.

7. - SLED selon la revendication 1, dans laquelle les différentes résistances sont formées de titane, de nickel et de chrome.

8. - SLED selon la revendication 1, dans laquelle une conception d'une ligne de charge du réseau de résistances est une conception distribuée de la pluralité de résistances.

9. - SLED selon la revendication 1, dans laquelle une conception d'une ligne de charge du réseau de résistances est une conception regroupée de la pluralité de résistances.

10. - SLED selon la revendication 1, dans laquelle, pour former le guide d'ondes actif, un masque ayant une première bande et une seconde bande est dessiné sur un substrat.

11. - SLED selon la revendication 10, dans laquelle la première bande et la seconde bande du masque sont de forme trapézoïdale, et dans laquelle une largeur de la première bande diminue d'une première extrémité de la première bande à une deuxième extrémité de la première bande, et une largeur de la seconde bande diminue d'une première extrémité de la seconde bande à une deuxième extrémité de la seconde bande.

12. - SLED selon la revendication 11, dans laquelle la première bande et la seconde bande sont séparées par un premier espace qui est constant.

13. - SLED selon la revendication 12, dans laquelle le guide d'ondes actif est formé dans le premier espace entre la première bande et la seconde bande, dans laquelle une épaisseur du guide d'ondes actif est plus grande à une extrémité arrière du guide d'ondes actif par rapport à une épaisseur à une extrémité avant du guide d'ondes actif, et dans laquelle l'extrémité arrière du guide d'ondes actif est formée par la première extrémité de la première bande et la première extrémité de la seconde bande, et l'extrémité avant du guide d'ondes actif est formée par la deuxième extrémité de la première bande et la deuxième extrémité de la seconde bande.

14. - SLED selon la revendication 10, dans laquelle une largeur de la première bande diminue d'une première extrémité de la première bande à une deuxième extrémité de la première bande, et une largeur de la première bande augmente ou diminue de la deuxième extrémité de la première bande à une troisième extrémité de la première bande, et dans laquelle une largeur de la seconde bande diminue d'une première extrémité de la seconde bande à une deuxième extrémité de la seconde bande, et une largeur de la seconde bande augmente ou diminue de la deuxième extrémité de la seconde bande à une troisième extrémité de la seconde bande.

15. - SLED selon la revendication 14, dans laquelle un premier espace entre les première et deuxième extrémités de la première bande et la seconde bande est un espace constant, et un second espace entre les deuxième et troisième extrémité de la première bande et la seconde bande est un espace variable.

16. - SLED selon la revendication 15, dans laquelle le guide d'ondes actif est formé dans le premier espace et le second espace entre la première bande et la seconde bande, dans laquelle (i) une épaisseur du guide d'ondes actif qui est formé dans le premier espace, diminue d'une extrémité arrière du guide d'ondes actif à une extrémité intermédiaire du guide d'ondes actif et (ii) une épaisseur du guide d'ondes actif qui est formé dans le second espace, augmente ou diminue de l'extrémité intermédiaire à une extrémité avant du guide d'ondes actif, et dans laquelle le guide d'ondes actif formé dans le second espace agit comme un convertisseur de taille de mode pour coupler un dispositif externe à la SLED.

17. - SLED selon la revendication 1, dans laquelle une extrémité arrière du guide d'ondes actif a une bande interdite inférieure par rapport à une extrémité avant du guide d'ondes actif.

18. - SLED selon la revendication 1, comprenant en outre des connexions d'alimentation qui couplent le réseau de résistances avec le patin de contact continu unique.

19. - SLED selon la revendication 1, dans laquelle le guide d'ondes actif comprend :
un ensemble de puits quantiques ; et
une paire de couches d'hétérostructure à confinement séparé (SCH), l'ensemble de puits quantiques étant pris en sandwich entre la paire de couches de SCH, où, sur la base du courant électrique injecté dans le guide d'ondes actif, chaque puits quantique de l'ensemble de puits quantiques émet de la lumière d'une longueur d'onde correspondante et d'une puissance optique correspondante, et la lumière superluminescente à large bande étant émise par une combinaison de la lumière émise à chaque longueur d'onde correspondante.

20. - SLED selon la revendication 1, dans laquelle le guide d'ondes actif supprime une rétro-réflexion de la lumière superluminescente à large bande.
